# EUROPÄISCHE PATENTANMELDUNG

(11) **EP 2 267 464 A2**
(43) Veröffentlichungstag der Anmeldung: **29.12.2010**
(21) Anmeldenummer: 10006510.1
(22) Anmeldetag: 23.06.2010
(51) Int. Cl.: G01R 11/04

(54) **Element zur Überbrückung zueinander im Abstand angeordneter elektrischer Leiter**

(30) Priorität: 25.06.2009 DE 102009030661; 14.07.2009 DE 102009049853
(71) Anmelder: Hager Electro GmbH & Co. KG, 66440 Blieskastel (DE)
(72) Erfinder: Kelaiditis, Konstantin, 66386 St. Ingbert (DE)
(74) Vertreter: Bernhardt, Reinold

(57) **Zusammenfassung**

Die Erfindung betrifft eine Element zur Überbrückung zueinander im Abstand angeordneter elektrischer Leiter (7,8), insbesondere Leiter für den Anschluss eines Stromzählers. Erfindungsgemäß sind zwei Paare (13,14;15,16) einander gegenüberliegender Klemmschenkel vorgesehen, zwischen denen die Leiter (7,8) einklemmbar sind.

## Beschreibung

Die Erfindung betrifft ein Element zur Überbrückung zueinander im Abstand angeordneter elektrischer Leiter, insbesondere Leiter für den Anschluss eines Stromzählers.

Aus der deutschen Patentanmeldung DE 10 2004 002 856 A1 geht z.B. ein Überbrückungselement hervor, dass in einer Anschlussvorrichtung für einen elektronischen Stromzähler zur Aufrechterhaltung des Stromflusses beim Lösen des Stromzählers von der Anschiussvorrichtung dient. Das als flacher Blechstreifen ausgebildete Überbrückungselement greift zwischen zangenartig daran angreifenden, elastischen Klemmschenkeln ein, die mit den zu überbrückenden Leitern verbunden sind. Zwischen diesen Klemmschenkeln kommen im Anschlusszustand des Stromzählers vom Stromzähler vorstehende Anschlusskontaktelemente zur Anordnung.

Der Erfindung liegt die Aufgabe zugrunde, ein neues Überbrückungselement der eingangs genannten Art zu schaffen, das bei vereinfachter Handhabung eine höhere Funktionssicherheit als bekannte derartige Überbrückungselemente bietet.

Das diese Aufgabe lösende Überbrückungselement nach der Erfindung ist gekennzeichnet durch zwei Paare einander gegenüberliegender Klemmschenkel, zwischen denen die Leiter einklemmbar sind.

Vorteilhaft ermöglichen die erfindungsgemäßen Klemmschenkel eine sichere Ankopplung des Überbrückungselements an die Leiter, während sich das Überbrückungselement in einer Führung selbst zentrieren kann.

In einer bevorzugten Ausführungsform der Erfindung sind die Klemmschenkelpaare durch im Abstand einander gegenüberliegende Platten gebildet, zwischen denen der jeweilige Leiter zur Anordnung kommt.
Insbesondere können die Klemmschenkelpaare durch Verschiebung des Überbrückungselements gleichzeitig auf die Leiter aufschiebbar sein, wobei das Überbrückungselement für den Eingriff eines der beiden Leiter zwischen den Klemmschenkelpaaren seitlich geöffnet ist. Durch Verschiebung des Überbrückungselements in nur einer Richtung ist somit ein elektrischer Kontakt zu beiden Leitern herstellbar.

In der bevorzugten Ausführungsform der Erfindung sind zur Bildung der Klemmschenkelpaare zwei, über die gesamte Länge des Elements durchgehende Platten gebildet, wobei die Platten vorzugsweise über einen Teil ihrer Länge im Bereich zwischen den Klemmschenkelpaaren miteinander verbunden sind.

Diese Verbindung kann insbesondere unter Bildung eines U-förmigen Querschnitts erfolgen, so dass die zur überbrückenden Leiter seitlich in das Überbrückungselement eingreifen können.

Vorzugsweise ist ein die Platten am Rand verbindender Steg gebildet. Je nach Länge der Verbindung durch den Steg werden unterschiedlich lange Klemmschenkel und damit gewünschte Beweglichkeiten der Klemmschenkel erreicht.

Die Platten können ferner die Beweglichkeit und die Federkräfte der Klemmschenkel beeinflussende Ausnehmungen aufweisen. Als solche Ausnehmungen kommen z.B. an den Steg angrenzende Einbuchtungen in Betracht.

Zweckmäßig stehen von den Klemmschenkeln eine hohe Flächenpressung sichernde Kontaktbuckel vor, insbesondere einander gegenüberliegende Kontaktbuckel, die abgerundet sind, so dass sich die Klemmschenkel leicht auf die Leiter aufschieben lassen.

In der bevorzugten Ausführungsform der Erfindung ist das Überbrückungselement einstückig aus einem einzigen Blechstanzteil hergestellt.

Die Erfindung wird nachfolgend anhand eines Ausführungsbeispiels und der beiliegenden, sich auf dieses Ausführungsbeispiel beziehenden Zeichnungen weiter erläutert. Es zeigen:
- Fig. 1: ein erfindungsgemäßes Überbrückungselement in einer perspektivischen An- sicht,
- Fig. 2: eine die Funktion des Überbrückungselements von Fig. 1 erläuternde Dar- stellung,
- Fig. 3: eine das Überbrückungselement von Fig. 1 verwendende Anschlussvorrich- tung für einen Stromzähler, in einer perspektivischen Teilansicht,
- Fig. 4: eine in der Anschlussvorrichtung von Fig. 3 verwendbare Schieberplatte in einer Teilansicht von unten,
- Fig. 5: die Schieberplatte von Fig. 4 in einer Teilansicht von oben, und
- Fig. 6: eine die Schieberplatte, das Überbrückungselement von Fig. 1 und ein zu überbrückendes Leiterstück zeigende Schnittansicht.

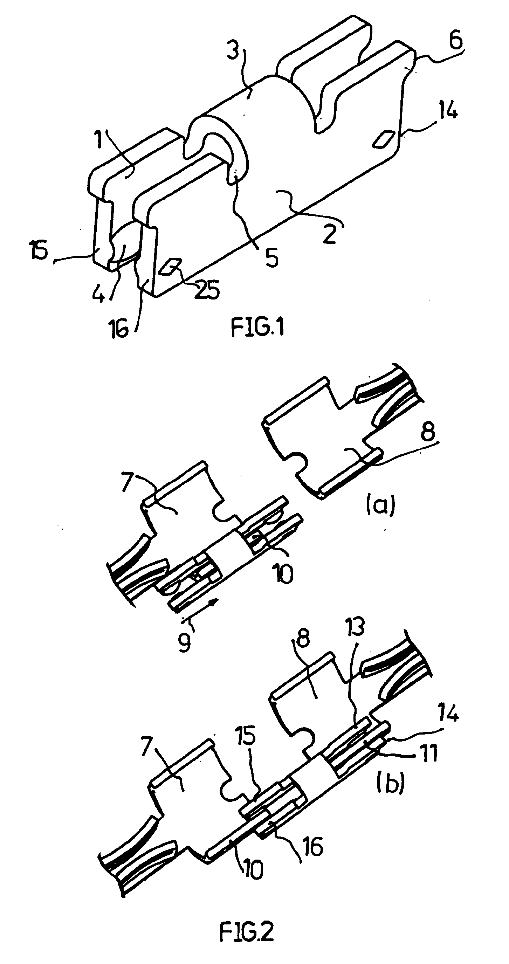

Ein in Fig. 1 dargestelltes Überbrückungselement ist einstückig aus einem Kupferblechstanzteil hergestellt und weist zwei einander im Abstand gegenüberliegende Platten 1 und 2 auf, die durch einen gebogenen Steg 3 miteinander verbunden sind.

Von den Platten 1 und 2 stehen innenseitig an beiden Enden einander gegenüberliegende Kontaktbuckel 4 vor. Den Kontaktbuckeln 4 entsprechen eingedrückte Vertiefungen 26 auf der Plattenaußenseite. Angrenzend an den Steg 3 weisen die Platten 1,2 Einbuchtungen 5 auf. Von den Ecken der Randseiten der Platten 1,2, die durch den Steg 3 miteinander verbunden sind, steht jeweils eine gerundete Nase 6 vor.

Wie Fig. 2 zeigt, lassen sich durch das Überbrückungselement im Abstand zueinander angeordnete Leiterstücke 7 und 8 elektrisch miteinander verbinden, indem das Überbrückungselement in Richtung des Pfeils 9 verschoben wird.

Wie aus Fig. 2a hervorgeht, greift im nicht überbrückten Zustand der Leiterstücke 7 und 8 zwischen den Platten 1 und 2 des Überbrückungselements ein schienenartig vorstehender Abschnitt 10 des Leiterstücks 7 ein.

Im überbrückten, in Fig. 2b gezeigten Zustand der Leiterstücke 7, 8 sind durch die Platten 1,2 gebildete Klemmschenkel 13 und 14 auf einen dem schienenförmigen Abschnitt 10 des Leiterstücks 7 entsprechenden Abschnitt 11 des Leiterstücks 8 aufgeschoben. Klemmschenkel 15 und 16 am entgegengesetzten Ende des Überbrückungselements klemmen den Abschnitt 10 ein.

Die abgerundeten Kontaktbuckel 4 gleiten bei Verschiebung des Überbrückungselements leicht auf die schienenartigen Abschnitte 10,11 auf, wobei sich die Klemmschenkelpaare 13,14 sowie 15,16 elastisch aufspreizen und dauerhaft eine Klemmkraft erzeugen. Zur Erleichterung des Aufgleitens können auch die schienenartigen Abschnitte 10, 11 an den betreffenden Enden gerundet sein.

Wie die nachfolgenden Figuren beispielhaft zeigen, kann das vorangehend beschriebene Überbrückungselement in einer Anschlussvorrichtung für einen elektronischen Stromzähler eingesetzt werden.

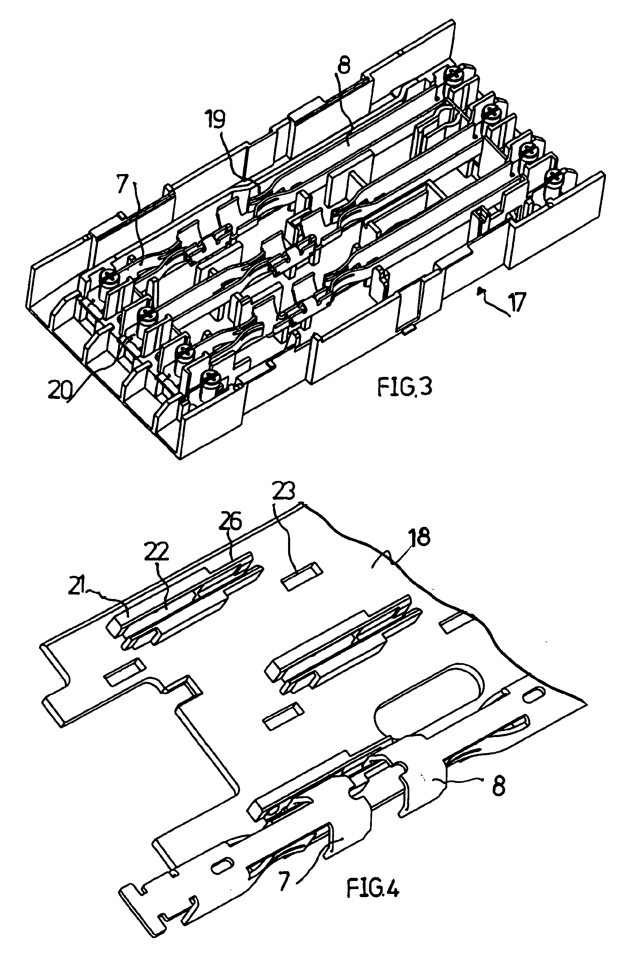

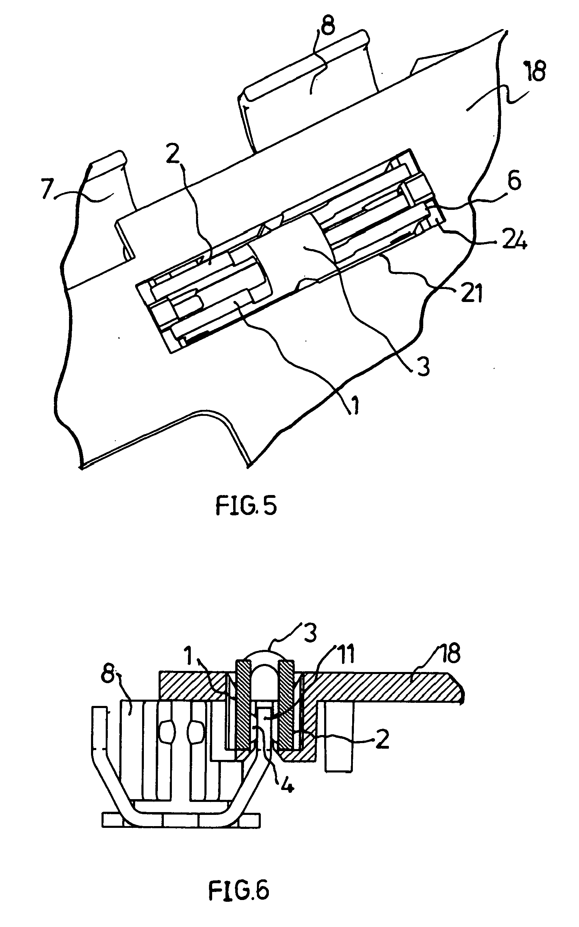

Fig. 3 zeigt eine Bodenbaugruppe 17 einer Anschlussvorrichtung für einen elektronischen Stromzähler, der auf eine (nicht dargestellte), auf der Bodenbaugruppe 17 angeordnete Tragplatte aufsetzbar ist, wie dies z.B. in der hier einbezogenen DE 10 2004 002 856 A1 beschrieben ist. Von dem Stromzöhlergehäuse vorstehende Anschlusskontaktelemente für drei Stromphasen stehen durch Öffnungen in der Tragplatte hindurch vor, um mit Anschlussleiterstücken 7 und 8 hinter der Tragplatte in Kontakt zu kommen. Zwischen der genannten Tragplatte und den Anschlussleiterstücken 7,8 befindet sich die in den Fig. 4 und 5 ausschnittsweise gezeigte Schieberplatte 18.

Fig. 3 zeigt die in Fig. 2 ausschnittsweise dargestellten Leiterstücke 7 und 8 vollständig, wobei drei Paare solcher Leiterstücke 7,8 für drei Stromphasen vorhanden sind. Die Leiterstücke weisen an einem Ende jeweils Paare 19 einander gegenüberliegender Klemmschenkel auf, zwischen denen jeweils ein Anschlusskontaktelement des Stromzählers einklemmbar ist. Am anderen Ende sind die Leiter 7,8 jeweils mit einem Schraubklemmanschlusselement 20 verbunden.

Wie aus den Figuren 4 und 5 hervorgeht, weist die Schieberplatte 18 Taschen 21 für die Aufnahme der Überbrückungselemente auf. Durch einen Öffnungsschlitz 22 auf ihrer den Leiterstücken 7,8 zugewandten Seite können die genannten Abschnitte 10,11 in die Tasche 21, und damit zwischen den Platten 1,2 des in der Tasche aufgenommenen Überbrückungselements eingreifen. In den Taschen 21 liegt das Überbrückungselement mit je zwei seiner vorstehenden Nasen 6 auf einer Schulter 24 auf. Schienenartige Verlängerungen 26 an den Taschen dienen der Führung der Schieberplatte.

Bei abgenommenem Stromzähler sind die Leiterstücke 6,7 durch die Überbrückungselemente elastisch verbunden, wobei sie die in Fig. 2b gezeigte Position einnehmen.

Beim Anschluss eines Stromzählers treten die genannten Anschlusskontaktelemente des Stromzählers durch die Schlitze 23 hindurch, wobei sie die Schlitze 23 im Querschnitt fast vollständig ausfüllen. Bei Verschiebung des Stromzählers auf der Tragplatte (entgegen der Richtung des Pfeils 9) wird die Schieberplatte 18 durch die Anschlusskontaktelemente des Stromzählers mitgenommen und verschoben. Die Schieberplatte 18 nimmt ihrerseits die in den Taschen 21 aufgenommenen Überbrückungselemente mit, so dass sie in die in Fig. 2a gezeigte Offenstellung gelangen. Gleichzeitig kommen die genannten Anschlusskontaktelemente des Stromzählers zwischen den Klemmschenkeln der Klemmschenkelpaare 19 zur Anordnung, so dass über die Leiterstücke 7,8 ein Strom durch den Stromzähler fließen kann.

Die Überbrückungselemente können in den Taschen 21 ein geringes Spiel aufweisen, und insbesondere quer zur Verschiebungsrichtung schwimmend gelagert sein, so dass Fertigungstoleranzen sowohl der Überbrückungselemente als auch der Schieberplatte ausgeglichen werden.

Gemäß Fig. 6 stehen die Überbrückungselemente aus den Taschen 21 über die Schieberplatte 18 hinaus vor. Es versteht sich, dass sie auch bündig mit der Schieberplatte abschließen könnten, so dass in der Tragplatte, welche die Überbrückungselemente in den Taschen 21 einschließt, keine entsprechenden Ausnehmungen vorgesehen werden müssen.

In dem gezeigten Ausführungsbeispiel dienen die Einbuchtungen 5 im Überbrückungselement nicht nur zur Beeinflussung der Federeigenschaften der Klemmschenkel 13 bis 16, sondern ermöglichen auch den gezeigten Biegungsradius des Verbindungsstegs 3.

## Patentansprüche

1. Element zur Überbrückung zueinander im Abstand angeordneter elektrischer Leiter, insbesondere Leiter (7,8) für den Anschluss eines Stromzählers, **gekennzeichnet durch** zwei Paare (13,14;15,16) einander gegenüberliegender Klemmschenkel, zwischen denen die Leiter (7,8) einklemmbar sind.

2. Überbrückungselement nach Anspruch 1,
**dadurch gekennzeichnet,**
**dass** die Klemmschenkelpaare (13,14;15,16) durch im Abstand einander gegenüberliegende Platten (1,2) gebildet sind, zwischen denen der jeweilige Leiter (7,8) zur Anordnung kommt.

3. Überbrückungselement nach Anspruch 1 oder 2,
**dadurch gekennzeichnet,**
**dass** die Klemmschenkelpaare (13,14;15,16) durch Verschiebung des Überbrückungselements gleichzeitig auf die Leiter (7,8) aufschiebbar sind, wobei das Überbrückungselement für den Eingriff eines der beiden Leiter (7,8) zwischen den Klemmschenkelpaaren (13,14;15,16) seitlich geöffnet ist.

4. Überbrückungselement nach einem der Ansprüche 1 bis 3,
**dadurch gekennzeichnet,**
**dass** zur Bildung der Klemmschenkelpaare (13,14;15,16) zwei, über die gesamte Länge des Überbrückungselements durchgehende, miteinander verbundene Platten (1,2) vorgesehen sind.

5. Überbrückungselement nach Anspruch 4,
**dadurch gekennzeichnet,**
**dass** die Platten (1,2) über einen Teil ihrer Länge im Bereich zwischen den Klemmschenkelpaaren (13,14;15,16) miteinander verbunden sind.

6. Überbrückungselement nach Anspruch 4 oder 5,
**dadurch gekennzeichnet,**
**dass** die Platten (1,2) unter Bildung eines U-förmigen Querschnitts miteinander verbunden sind.

7. Überbrückungselement nach einem der Ansprüche 4 bis 6,
**dadurch gekennzeichnet,**
**dass** ein die Platten (1,2) am Rand verbindender Steg (3) gebildet ist.

8. Überbrückungselement nach Anspruch 7,
**dadurch gekennzeichnet,**
**dass** die Platten (1,2) die Beweglichkeit der Klemmschenkel (13-16) beeinflussende Ausnehmungen (5) aufweisen.

9. Überbrückungselement nach Anspruch 8,
**dadurch gekennzeichnet,**
**dass** als solche Ausnehmungen an den Steg (3) angrenzende Einbuchtungen (5) gebildet sind.

10. Überbrückungselement nach einem der Ansprüche 1 bis 9,
**dadurch gekennzeichnet,**
**dass** von den Klemmschenkeln (13-16) Kontaktbuckel (4), insbesondere einander gegenüberliegende Kontaktbuckel, vorstehen.

11. Überbrückungselement nach einem der Ansprüche 1 bis 10,
**dadurch gekennzeichnet,**
**dass** das Überbrückungselement einstückig aus einem einzigen Blechstanzteil hergestellt ist.

12. Überbrückungselement nach einem der Ansprüche 1 bis 11,
**dadurch gekennzeichnet,**
**dass** das Überbrückungselement in eine Haltetasche (21) einlegbar ist.

13. Überbrückungselement nach Anspruch 12,
**dadurch gekennzeichnet,**
**dass** das Überbrückungselement mit von den Klemmschenkeln (13-16) vorstehenden Haltenasen (6) auf in der Haltetasche (21) ausgebildete Schultern (24) auflegbar ist.

14. Überbrückungselement nach Anspruch 13,
**dadurch gekennzeichnet,**
**dass** die Haltenasen (6) abgerundet sind.
